# EUROPEAN PATENT SPECIFICATION

(11) **EP 1 801 882 B1**
(45) Date of publication and mention of the grant of the patent: **20.07.2016**
(21) Application number: 06256466.1
(22) Date of filing: 20.12.2006
(51) Int. Cl.: H01L 51/54

(54) **Organic luminescence display device and method of manufacturing the same**
Organische Lumineszenzanzeigevorrichtung und Herstellungsverfahren dafür
Dispositif d'affichage électroluminescent organique et son procédé de fabrication

(30) Priority: 20.12.2005 KR 20050126101; 26.12.2005 KR 20050129922
(43) Date of publication of application: 27.06.2007
(73) Proprietor: Samsung Display Co., Ltd., Gyeonggi-do (KR)
(72) Inventor: Chun, Min-Seung, c/o Samsung SDI Co., Ltd., Gyeonggi-do (KR); Kim, Mi-Kyung, c/o Samsung SDI Co., Ltd., Gyeonggi-do (KR); Kim, Dong-Hun, c/o Samsung SDI Co., Ltd., Gyeonggi-do (KR); Son, Jung-Ha, c/o Samsung SDI Co., Ltd., Gyeonggi-do (KR); Kwak, Jae-Hyun, c/o Samsung SDI Co., Ltd., Gyeonggi-do (KR)
(74) Representative: Mounteney, Simon James

(56) References cited:
- EP-A2- 1 531 501
- WO-A1-03/043383
- WO-A1-2004/105447
- WO-A2-2005/076753
- US-A1- 2003 116 772
- US-A1- 2005 142 384

## Description

### BACKGROUND

### Field of the Invention

The present invention relates to an organic luminescence display device and a method of manufacturing the same, and more particularly, to an organic luminescence display device having a charge generation layer, and a method of manufacturing the same.

### Description of the Related Technology

Electroluminescent (EL) devices, which are self-emissive display devices, have attracted attention because of their advantages such as a wide viewing angle, high contrast, and a short response time. EL devices are classified into inorganic EL devices and organic EL devices according to the materials used to form emission layers of the EL devices. Organic EL devices have good brightness and driving voltage, and a short response time. Organic EL devices can also display multiple color images.

In general, organic luminescence display devices have an anode formed on a substrate. Organic EL devices also include a hole transport layer (HTL), an emission layer (EML), an electron transport layer (ETL) and a cathode sequentially stacked over the anode. Here, the HTL, EML and ETL include organic thin films formed of organic compounds.

The organic EL device described above may be operated as follows. A voltage is applied between the anode and the cathode. Then, holes are injected from the anode to the emission layer via the hole transport layer. Electrons are injected to the emission layer via the electron transport layer from the cathode. The electrons and holes recombine with each other in the emission layer, thereby forming excitons having an excited energy state. The excitons, while returning from the excited state to a ground state, cause fluorescent molecules of the emission layer to emit light.

In top-emission type organic luminescence display devices, the thicker the device profile is, the better the microcavity effect is. The microcavity effect refers to a phenomenon that a wavelength of light emitted from a display device depends on a path along which the light travels within the device. In addition, a device with a thick profile may minimize image defects caused by particles.

However, as the total thickness of the device increases, an increase in driving voltage, which can be a problem, occurs. To maximize its efficiency, there is a need to provide a suitable light path which permits light to have a wavelength closest to its original wavelength. The light path may be adjusted by changing the thickness of an organic layer of the device. In general, the thicker the organic layer is, the longer a light wavelength is. The thickest portion of the organic layer is a red (R) emission layer, and the thinnest portion of the organic layer is a blue (B) emission layer. The range of the thickness has a preferable period thickness and a maximum light extraction efficiency can be obtained. A one-period thickness is too thin to prevent a poor emission due to particles. A two-period thickness is too thick to prevent an increase in the driving voltage even though the two-period thickness may prevent a poor emission due to particles. EP1531501, WO03043383 and WO2005076753 all disclose organic electroluminescent devices. WO2004105447 discloses an organic electroluminescent device using an Indium Tin Oxide film.

### SUMMARY

A first aspect of the invention provides an organic luminescence display device as set out in claim 1. Preferred features are set out in claims 2 to 12.

A second aspect of the invention provides an electronic device comprising an organic luminescence display device as set out in claim 13.

A third aspect of the invention provides a method of manufacturing an organic luminescence display device as set out in claim 11. Preferred features are set out in claims 15 to 21.

### BRIEF DESCRIPTION OF THE DRAWINGS

The above and other aspects of the invention will become more apparent by describing in detail exemplary embodiments thereof with reference to the attached drawings in which:
FIG. 1 is a cross-sectional view of an organic luminescence display device; and
FIGS. 2A through 2C are cross-sectional views illustrating a method of manufacturing an organic luminescence display device according to an embodiment.

### DETAILED DESCRIPTION

Hereinafter, embodiments of the invention will be described in detail with reference to the attached drawings.

An organic electroluminescent (EL) display device having an emission layer between a first electrode and a second electrode according to an embodiment includes a first hole injection layer and a second hole injection layer between the first electrode and the emission layer. The organic EL device includes a charge generation layer between the first hole injection layer and the second hole injection layer. The charge generation layer is doped with a p-type dopant. An electron transport layer is interposed between the second electrode and the emission layer and comprises an electron injection layer interposed between the electron transport layer and the second electrode and the device comprises a plurality of pixels, and the charge generation layer forms a common layer for at least two of the pixels

The charge generation layer includes a compound represented by Formula 1:

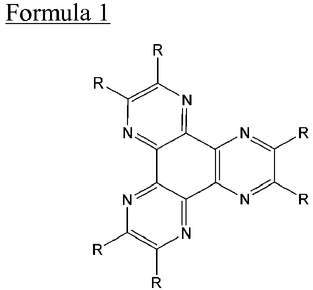

In Formula 1, R is a nitrile (-CN) group, a sulfone (-SO₂R') group, a sulfoxide (-SOR') group, a sulfone amide(-SO₂NR'₂) group, a sulfonate (-SO₃R') group, a nitro(-NO₂) group, or a trifluoromethyl (-CF₃) group (where R' is a C₁-C₆₀ alkyl group, a C₆-C₆₀ aryl group, or a C₁-C₆₀ heterocyclic group and is unsubstituted or substituted with amine, amide, ether, or ester). Examples of the compound of Formula 1 include, but are not limited to, compounds represented by the following formulas:

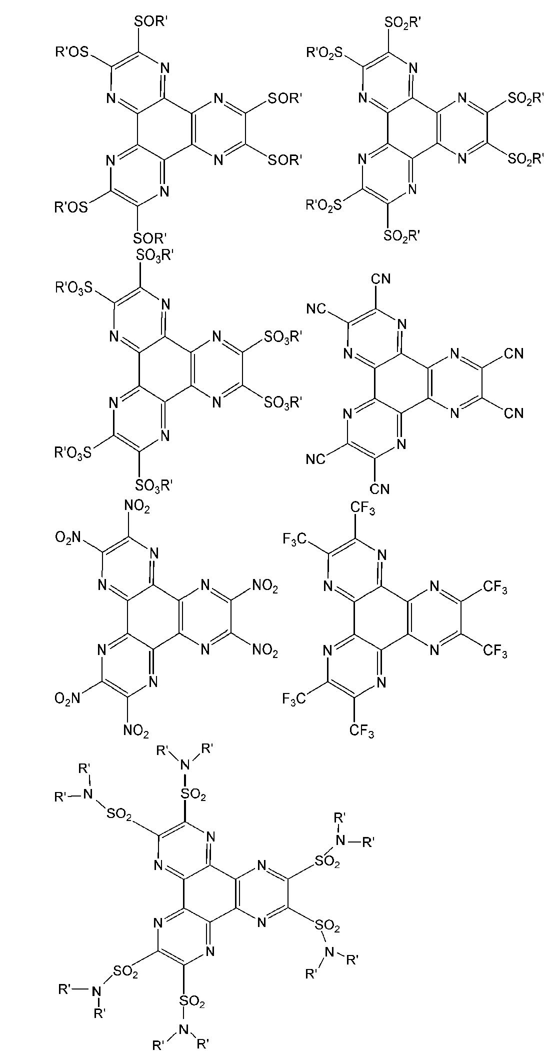

In the above formulas, R' is a C₁-C₆₀ alkyl group, a C₆-C₆₀ aryl group, or C₁-C₆₀ heterocyclic group and is unsubstituted or substituted with amine, amide, ether, or ester. Organic materials for forming the charge generation layer represented by the above formulas are for illustrative purposes only, but are not limited thereto.

The p-type dopant in the charge generation layer may be one selected from hexanitrile hexaazatriphenylene, tetrafluoro-tetracyanoquinodimethane (F₄-TCNQ), FeCl₃, F₁₆CuPc and a metal oxide. The metal oxide may be vanadium oxide (V₂O₅) rhenium oxide (Re₂O₇), or indium tin oxide (ITO).

The p-type dopant material may be a material having an energy level different from that of a material for the first and/or second hole injection layers. A difference between a lowest unoccupied molecular orbital (LUMO) energy level of the p-type dopant material and a highest occupied molecular orbital (HOMO) energy level of the material for the first hole injection layer and/or the second hole injection layer may be of from about -2 eV to about +2 eV.

For example, hexaazatriphenylene has a HOMO energy level of about 9.6 eV to about 9.7 eV, and a LUMO energy level of about 5.5 eV. In addition, tetrafluoro-tetracyanoquinodimethane (F₄-TCNQ) has a HOMO energy level of about 8.53 eV, and a LUMO energy level of about 6.23 eV. The first and second hole injection layer material used in the organic luminescent display device according to the current embodiment has a HOMO energy level of about 4.5 eV to about 5.5 eV. Accordingly, when hexaazatriphenylene is used as the p-type dopant material, the difference between the LUMO energy level of the charge generation layer and the HOMO energy level of the first hole injection layer material or the second hole injection layer material is about -1.0 eV to 0 eV. In addition, when tetrafluoro-tetracyanoquinodimethane (F4-TCNQ) is used as the p-type dopant material in the charge generation layer, the difference between the LUMO energy level of the charge generation layer and the HOMO energy level of the first hole injection layer or the second hole injection layer is about -0.73 to about 1.73 eV.

By forming the charge generation layer between the first hole injection layer and the second hole injection layer using the charge generating material, driving voltage of the organic luminescent display device can be reduced.

According to an embodiment, the charge generation layer can be formed using resistance heating vapor deposition, electron beam vapor deposition, laser beam vapor deposition, sputtering deposition or the like. The charge generation layer can be formed of a compound represented by Formula 1 in which R' in Formula 1 is a C₅-C₆₀ alkyl group unsubstituted or substituted with amine, amide, ether, or ester. The charge generation layer may be formed by ink-jet printing, spin coating, doctor blading, roll coating or the like. In these methods, the charge generation layer is formed using a solution instead of using a vapor deposition method.

In one embodiment, the charge generation layer can form a common layer for each of a plurality of pixels. The charge generation layer may have a thickness of about 10Å to about 200 Å, and optionally about 20 to about 80 Å. When the thickness of the charge generation layer is less than 10 Å, a charge generating effect is lower. When the thickness of the generation layer is greater than 200 Å, driving voltage is increased or cross-talk due to a leakage current can occur.

The organic luminescence display device according to the current embodiment may further include a hole transport layer between the first electrode and the emission layer. The device may also include at least one of a hole blocking layer, an electron transport layer and an electron injection layer between the emission layer and the second electrode.

According to another embodiment, there is provided a method of manufacturing an organic luminescence display device having an emission layer between a first electrode and a second electrode. The method includes: forming a first hole injection layer on the first electrode; forming a charge generation layer doped with a p-type dopant on the first hole injection layer; and forming a second hole injection layer over and contacting the charge generation layer. The method of manufacturing the organic luminescence display device according to the current embodiment will now be described in detail.

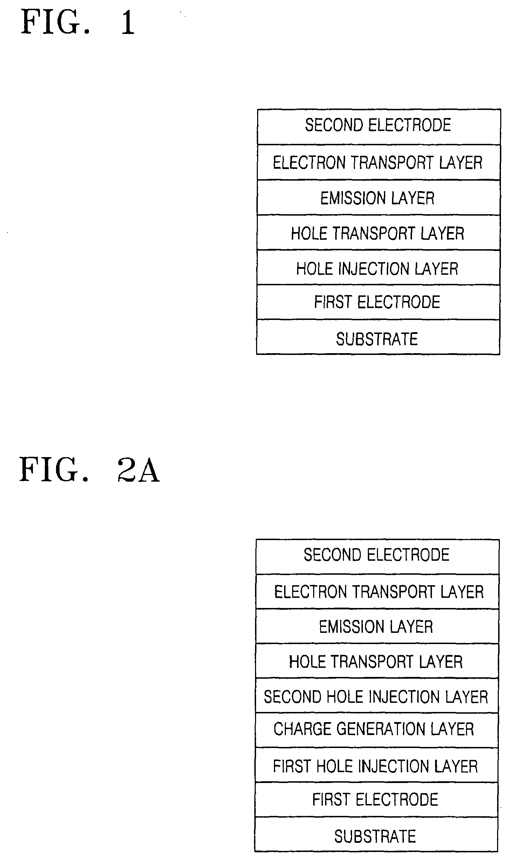

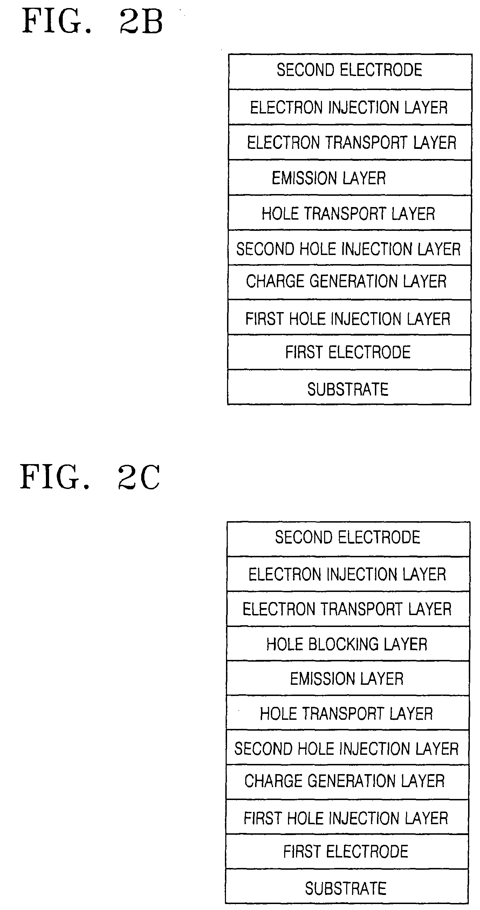

FIGS. 2A through 2C illustrate a method of manufacturing an organic luminescence display device according to an embodiment of the invention. First, a material for an anode (a first electrode), is deposited on a substrate to form the anode. Here, any substrate suitable for an organic luminescence display device may be used as a substrate. Examples of the substrate may include, but are not limited to, a glass or transparent plastic substrate that has good transparency, surface smoothness, ease of handling and water-proofness. The anode material may include a high work function metal (≥ about 4.5eV), or indium tin oxide (ITO), indium zinc oxide (IZO), tin oxide (SnO2), zinc oxide (ZnO) or the like that are transparent and highly conductive.

A first hole injection (HIL) layer may be formed on the anode. The first hole injection layer can be formed by thermally evaporating a material for the hole injection layer in a high vacuum. In other embodiments, the material may be used in a form of solution. In such embodiments, the layer may be formed by spin-coating, dip-coating, doctor-blading, inkjet printing, or thermal transfer, organic vapor phase deposition (OVPD) or the like.

The first hole injection layer (HIL) may be formed using vacuum thermal deposition, spin coating or the like as described above. The thickness of the first hole injection layer may be in a range of from about 100Å to about 1,500Å. When the thickness of the first hole injection layer is less than 100 Å, the hole injection characteristic deteriorates. When the thickness of the first hole injection layer is greater than 1,500 Å, driving voltage is increased. In one embodiment for top emission type organic luminescence display devices, the thickness of the first hole injection layer may be in a range of from about 1,000 to about 1,500 Å.

Examples of the material for the first hole injection layer include, but are not limited to, copper phthalocyanine (CuPc) or starburst-type amine series such as TCTA, m-MTDATA, IDE406 (available from Idemitsu Kosan Co., Ltd, Tokyo, Japan) and the like. Below are the chemical formulas of CuPc, TCTA, and m-MTDATA.

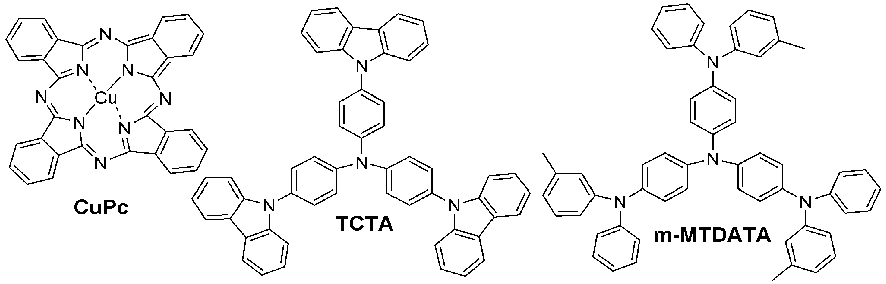

. The material for forming the charge generation layer is a compound represented by Formula 1 as follows:

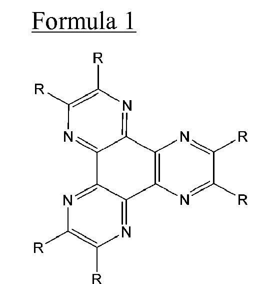

In Formula 1, R is a nitrile (-CN) group, a sulfone (-SO₂R') group, a sulfoxide (-SOR') group, a sulfone amide (-SO₂NR'₂) group, a sulfonate (-SO₃R') group, a nitro (-NO₂) group, or a trifluoromethyl (-CF₃) group. R' is a C₁-C₆₀ alkyl group, a C₆-C₆₀ aryl group, or a C₁-C₆₀ heterocyclic group and is unsubstituted or substituted with amine, amide, ether, or ester.

The charge generation layer is doped with a p-type dopant. The p-type dopant can be at least one of hexanitrile hexaazatriphenylene, tetrafluoro-tetracyanoquinodimethane (F₄-TCNQ), FeCl₃, F₁₆CuPc and a metal oxide. The metal oxide may be vanadium oxide (V₂O₅), rhenium oxide (Re₂O₇), or indium tin oxide(ITO).

The charge generation layer can be formed by depositing a material for the charge generation layer on the first hole injection layer using resistance heating vapor deposition, electron beam vapor deposition, laser beam vapor deposition, sputtering or the like. The charge generation layer can form a common layer for a plurality of pixels. The charge generation layer may have a thickness in a range of from about 10Å to about 200Å, and optionally of from about 20Å to about 80Å. When the thickness of the charge generation layer is less than 10 Å, a charge generating effect is reduced. When the thickness of the charge generation layer is greater than 200 Å, driving voltage is increased.

A second hole injection layer (HIL) is formed by depositing a second hole injection layer material on the charge generation layer. The second HIL may be formed using various methods, such as vacuum thermal deposition, spin coating or the like. The material for the second hole injection layer is not particularly limited, but may be the same material as that used for the first hole injection layer. The thickness of the second hole injection layer may be in a range of from about 50Å to about 1,000Å.

When the thickness of the second hole injection layer is less than 50 Å, a hole transporting characteristic deteriorates. When the thickness of the second hole injection layer is greater than 1,000 Å, driving voltage is increased.

A hole transport layer (HTL) may be optionally formed by depositing a hole transport layer material on the second hole injection layer. The HTL may be formed using various methods, such as vacuum thermal deposition, spin coating or the like. Examples of the hole transport layer material include, but are not limited to, N,N'-bis(3-methylphenyl)-N,N'-diphenyl-[1,1-biphenyl]-4,4'-deamine(TPD), N,N'-di(naphthalene-1-yl)-N,N'-diphenyl benzidine(α-NPD), IDE 320 (available from Idemitsu Kosan Co., Ltd.) and the like. The thickness of the hole transport layer may be in a range of from about 50 Å to about 500 Å.

When the thickness of the hole transport layer is less than 50 Å, a hole transporting characteristic deteriorates. When the thickness of the hole transport layer is greater than 500 Å, driving voltage is increased.

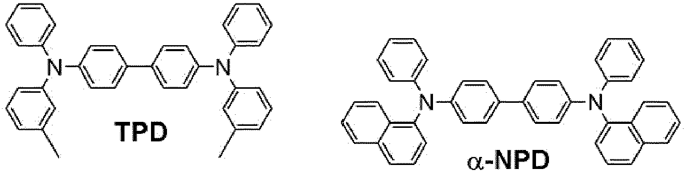

An emission layer (EML) may be formed on the hole transport layer. The method of forming the emission layer is not particularly limited, and various methods such as vacuum deposition, ink-jet printing, laser induced thermal imaging, photolithography, organic vapor phase deposition (OVPD) and the like can be used to form the emission layer. The thickness of the emission layer may be in a range of from about 100 to about 800 Å.

When the thickness of the emission layer is less than 100 Å, efficiency and lifetime thereof is reduced. When the thickness of the emission layer is greater than 800 Å, driving voltage is increased.A hole blocking layer (HBL) may be optionally formed by depositing a material for forming the HBL on the emission layer using vacuum deposition or spin coating as described above. The material for forming the HBL is not particularly limited, but may be a material having an electron transporting ability and higher ionized potential than that of an emissive compound. Examples of the material for forming the HBL include Balq, BCP, TPBI and the like. The thickness of the hole blocking layer may be in a range of from about 30 Å to about 500 Å.

When the thickness of the hole blocking layer is less than 30 Å, a hole blocking characteristic is poor leading to reduced efficiency. When the thickness of the hole blocking layer is greater than 500 Å, driving voltage is increased.

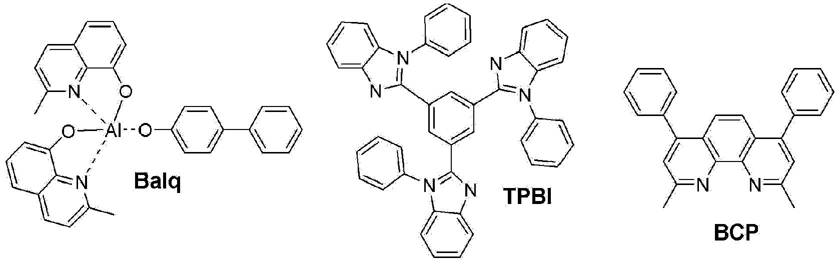

An electron transport layer (ETL) may be formed on the hole blocking layer using vacuum deposition or spin coating. The material for the electron transport layer is not particularly limited and can be Alq3. The thickness of the electron transport layer may be in a range of from about 50 Å to about 600 Å.

When the thickness of the electron transport layer is less than 50 Å, lifetime of the device is reduced. When the thickness of the electron transport layer is greater than 600 Å, driving voltage is increased.

In addition, an electron injection layer (EIL) can be optionally formed on the electron transport layer. Materials for forming the electron injection layer can be LiF, NaCl, CsF, Li₂O, BaO, Liq and the like. The thickness of the electron injection layer may be about 1 Å to about 100 Å.
When the thickness of the electron injection layer is less than 1 Å, it can not effectively act as an electron injection layer. When the thickness of the electron injection layer is greater than 100 Å, it acts as an insulation layer, thereby having a high driving voltage.

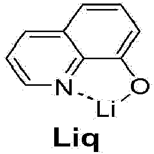

Subsequently, a cathode (or a second electrode) may be formed by depositing a metal for forming the cathode on the electron injection layer. The cathode may be formed using vacuum thermal deposition, sputtering, metal-organic chemical vapor deposition and the like. Examples of the metal for forming the cathode include, but are not limited to, lithium (Li), magnesium (Mg), aluminum (Al), aluminum-lithium (Al-Li), calcium (Ca), magnesium-indium (Mg-In), and magnesium-silver (Mg-Ag).

As described above, the organic luminescence display device according to the current embodiment includes an anode, a first hole injection layer, a charge generation layer, a second hole injection layer, a hole transport layer, an emission layer, an electron transport layer, an electron injection layer and a cathode. The device may further include an intermediate layer between two of the foregoing layers. The device may further include an electron blocking layer between the emission layer and the hole transport layer.

Hereinafter, embodiments of the present invention will be described in further detail with reference to the following examples. These examples are for illustrative purposes only and are not intended to limit the scope of the invention.

### Reference Example 1

A 15Ω/cm² (1200 Å) Corning ITO glass substrate (available from Corning, Inc., Corning, NY) as an anode was cut to be 50mm x 50mm x 0.7mm and washed with ultrasonic waves for 5 minutes each in isopropyl alcohol and pure water, respectively, and then cleaned with UV and ozone for 30 minutes.

m-MTDATA was vacuum deposited on the substrate to form a 1,300 Å thick first hole injection layer. Hexaazatriphenylene as a material for forming a charge generation layer was deposited on the first hole injection layer to a thickness of 20 Å using resistance thermal vapor deposition. Copper m-MTDATA was vacuum deposited on the charge generation layer to form a 200 Å thick second hole injection layer. N, N'-di(1- naphthyl)-N, N'- diphenyl benzidine (α-NPD) was vacuum deposited on the second hole injection layer to form a 200 Å thick hole transport layer.

An emission layer having a thickness of about 400 Å was formed using organic vapor phase deposition (OVPD). An electron transporting material, Alq3 was deposited on the emission layer to form a 300 Å thick electron transport layer. 10 Å of LiF (electron injection layer) and 200 Å of a Mg-Ag alloy (cathode) were sequentially vacuum deposited on the electron transport layer to form a LiF/Al electrode, and thus an organic luminescence display device was completed.

### Reference Example 2

An organic luminescence display device was manufactured in the same manner as in Example 1, except that the thickness of a charge generation layer was 50 Å.

### Reference Example 3

An organic luminescence display device was manufactured in the same manner as in Example 1, except that a thickness of a charge generation layer was 80 Å.

### Comparative Example 1

A 15 Ω/cm² (1200 Å) Corning ITO glass substrate as an anode was cut to be 50mm x 50mm x 0.7mm and washed with ultrasonic waves for 5 minutes each in isopropyl alcohol and pure water, respectively, and then cleaned with UV and ozone for 30 minutes.

m-MTDATA was vacuum deposited on the substrate to form a 1,500 Å thick hole injection layer. N, N'-di (1- naphthyl)-N, N'- diphenyl benzidine (α -NPD) was vacuum deposited on the hole injection layer to form a 200 Å thick hole transport layer.

An emission layer having a thickness of about 400 Å was formed using organic vapor phase deposition (OVPD). An electron transporting material, Alq3 was deposited on the emission layer to form a 300 Å thick electron transport layer. 10 Å of LiF (electron injection layer) and 200 Å of Mg-Ag alloy (cathode) were sequentially vacuum deposited on the electron transport layer to form an LiF/Al electrode, and thus an organic luminescence display device as illustrated in FIG. 1 was manufactured.

Driving voltages, efficiencies and lifetimes of the organic luminescence display devices manufactured according to Examples 1 through 3 and Comparative Example 1 were measured, and the results are shown in Table 1 below.

| | Driving voltage (V) | Efficiency (cd/A) | Lifetime (hour) |
|---|---|---|---|
| Example 1 | 5.73 | 27.18 | 1,500 |
| Example 2 | 5.71 | 26.90 | 1,500 |
| Example 3 | 5.60 | 26.85 | 1,500 |
| Comparative Example 1 | 7.59 | 26.79 | 1,000 |

In Examples 1 through 3, the driving voltages are 5.73-5.60 V, and in Comparative Example 1, the driving voltage is 7.59 V. In addition, in Examples 1 through 3, the efficiencies are 27.18-26.90 cd/A at a brightness of 1,900 cd/m², and in Comparative Example 1, the efficiency is 26.85 cd/A at a brightness of 1,900 cd/m².

In addition, the lifetime is defined as time taken for brightness to be reduced to 50 % of the initial brightness. In Examples 1 through 3, the lifetimes are about 1,500 hours at 9,500 cd/m², and in Comparative Example 1, the lifetime is about 1,000 hours at 9,500cd/m². As a result, it can be seen that the lifetimes of Examples 1-3 are about 1.5 times that of Comparative Example 1.

The organic luminescence display device according to the present disclosure includes a charge generation layer, thereby reducing driving voltage organic luminescence display device and improving efficiency and lifetime thereof.

While the present invention has been particularly shown and described with reference to embodiments thereof, it will be understood by those of ordinary skill in the art that various changes in form and details may be made therein without departing from the scope of the present invention as defined by the following claims.

## Claims

1. An organic luminescence display device comprising:
a first electrode;
a second electrode;
an emission layer interposed between the first and second electrodes;
a first hole injection layer interposed between the first electrode and the emission layer;
a second hole injection layer interposed between the first hole injection layer and the emission layer; and
a charge generation layer interposed between the first hole injection layer and the second hole injection layer, the charge generation layer being doped with a p-type dopant, **characterised in that** the charge generation layer comprises a compound represented by Formula 1: 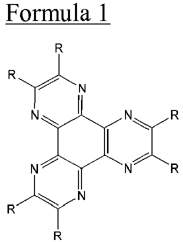
wherein R is a nitrile (-CN) group, a sulfone (-SO₂R') group, a sulfoxide (-SOR') group, a sulfonamide (-SO₂NR'₂) group, a sulfonate (-SO₃R') group, a nitro (-NO₂) group, or a trifluoromethyl (-CF₃) group; and
wherein R' is a C₁-C₆₀ alkyl group, a C₆-C₆₀ aryl group, or a C₁-C₆₀ heterocyclic group and is unsubstituted or substituted with amine, amide, ether, or ester.

2. An organic luminescence display device according to Claim 1, wherein the p-type dopant comprises at least one selected from the group consisting of hexanitrile hexaazatriphenylene, tetrafluoro-tetracyanoquinodimethane (F₄-TCNQ), FeCl₃, F₁₆CuPc and a metal oxide.

3. An organic luminescence display device according to Claim 2, wherein the metal oxide comprises at least one selected from the group consisting of vanadium oxide (V₂O₅), rhenium oxide (Re₂O₇), and indium tin oxide (ITO).

4. An organic luminescence display device according to any preceding claim, wherein the p-type dopant has a lowest unoccupied molecular orbital (LUMO) energy level, wherein at least one of the first and second hole injection layers comprises a material having a highest occupied molecular orbital (HOMO) energy level, and wherein a difference between the lowest unoccupied molecular orbital (LUMO) energy level of the p-type dopant and the highest occupied molecular orbital (HOMO) energy level of the material of the at least one of the first and second hole injection layers is between -2 eV and +2 eV.

5. An organic luminescence display device according to any preceding claim, wherein the device comprises a plurality of pixels, and wherein the charge generation layer forms a common layer for at least two of the pixels.

6. An organic luminescence display device according to any preceding claim, wherein the charge generation layer has a thickness is in a range of from 10 Å to 200 Å.

7. An organic luminescence display device according to Claim 6, wherein the charge generation layer has a thickness in a range of from 20 Å to 80 Å.

8. An organic luminescence display device according to any preceding claim, further comprising a hole transport layer interposed between the first electrode and the emission layer, and at least one of a hole blocking layer, an electron transport layer and an electron injection layer interposed between the emission layer and the second electrode.

9. An organic luminescence display device according to any preceding claim, further comprising an electron transport layer interposed between the second electrode and the emission layer.

10. An organic luminescence display device according to any preceding claim, further comprising a substrate, wherein the first electrode is formed over the substrate.

11. An organic luminescence display device according to Claim 9 or 10, further comprising an electron injection layer interposed between the electron transport layer and the second electrode.

12. An organic luminescence display device according to any one of Claims 9 to 11, further comprising a hole blocking layer interposed between the electron transport layer and the emission layer.

13. An electronic device comprising an organic luminescence display device according to any preceding claim.

14. A method of manufacturing an organic luminescence display device, the method comprising:
forming a first hole injection layer over a first electrode;
forming a charge generation layer over the first hole injection layer, the charge generation layer being doped with a p-type dopant; and
forming a second hole injection layer over and contacting the charge generation layer, **characterised in that** the charge generation layer comprises a compound represented by Formula 1: 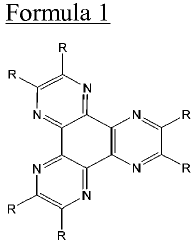
wherein R is a nitrile(-CN) group, a sulfone(-SO₂R') group, a sulfoxide(-SOR') group, a sulfonamide(-SO₂NR'₂) group, a sulfonate(-SO₃R') group, a nitro(-NO₂) group, or a trifluoromethyl(-CF₃) group; and
wherein R' is a C₁-C₆₀ alkyl group, a C₆-C₆₀ aryl group, or a C₁-C₆₀ heterocyclic group is unsubstituted or substituted with amine, amide, ether, or ester.

15. A method according to Claim 14, further comprising:
forming an emission layer over the second hole injection layer; and
forming a second electrode over the emission layer.

16. A method according to Claim 15, further comprising:
forming a hole transport layer after forming the second hole injection layer and before forming the emission layer; and
forming at least one of a hole blocking layer, an electron transport layer, and an electron injection layer after forming the emission layer and before forming the second electrode.

17. A method according to any one of Claims 14 to 16, wherein the p-type dopant comprises at least one selected from the group consisting of hexanitrile hexaazatriphenylene, tetrafluoro-tetracyanoquinodimethane (F₄-TCNQ), FeCl₃, F₁₆CuPc and a metal oxide.

18. A method according to Claim 17, wherein the metal oxide is at least one selected from the group consisting of vanadium oxide (V₂O₅), rhenium oxide (Re₂O₇), and indium tin oxide (ITO).

19. A method according to any one of Claims 14 to 18, wherein the p-type dopant has a lowest unoccupied molecular orbital (LUMO) energy level, wherein at least one of the first and second hole injection layers comprises a material having a highest occupied molecular orbital (HOMO) energy level, and wherein a difference between the lowest unoccupied molecular orbital (LUMO) energy level of the p-type dopant and the highest occupied molecular orbital (HOMO) energy level of the material of the at least one of the first and second hole injection layers is between -2 and +2 eV.

20. A method according to any one of Claims 14 to 19, wherein forming the charge generation layer comprises using resistance heating vapor deposition, electron beam vapor deposition, laser beam vapor deposition, or sputtering deposition.

21. A method according to any one of Claims 14 to 21, wherein the charge generation layer has a thickness in a range of from 10 Å to 200 Å.

## Patentansprüche

1. Organische Lumineszenzanzeigevorrichtung, umfassend:
eine erste Elektrode;
eine zweite Elektrode;
eine Emissionsschicht, die zwischen der ersten und der zweiten Elektrode eingefügt ist;
eine erste Lochinjektionsschicht, die zwischen der ersten Elektrode und der Emissionsschicht eingefügt ist;
eine zweite Lochinjektionsschicht, die zwischen der ersten Lochinjektionsschicht und der Emissionsschicht eingefügt ist; und
eine Ladungserzeugungsschicht, die zwischen der ersten Lochinjektionsschicht und der zweiten Lochinjektionsschicht eingefügt ist, wobei die Ladungserzeugungsschicht mit einem p-Typ-Dotierungsstoff dotiert ist, **dadurch gekennzeichnet, dass** die Ladungserzeugungsschicht eine Verbindung umfasst, die durch Formel 1 dargestellt wird: 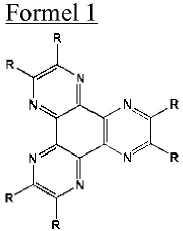
wobei R eine Nitril-(-CN)-Gruppe, eine Sulfon-(-SO₂R')-Gruppe, eine Sulfoxid-(-SOR')-Gruppe, eine Sulfonamid-(-SO₂NR'₂)-Gruppe, eine Sulfonat-(-SO₃R')-Gruppe, eine Nitro-(-NO₂)-Gruppe oder eine Trifluormethyl-(-CF₃)-Gruppe ist; und
wobei R' eine C₁-C₆₀-Alkylgruppe, eine C₆-C₆₀-Arylgruppe oder eine heterocyclische C₁-C₆₀-Gruppe ist und nicht substituiert ist oder mit Amin, Amid, Ether oder Ester substituiert ist.

2. Organische Lumineszenzanzeigevorrichtung nach Anspruch 1, wobei der p-Typ-Dotierungsstoff zumindest eines umfasst, das aus der Gruppe, bestehend aus Hexanitrilhexaazatriphenylen, Tetrafluor-tetracyanchinodimethan (F₄-TCNQ), FeCl₃, F₁₆CuPc und einem Metalloxid, ausgewählt ist.

3. Organische Lumineszenzanzeigevorrichtung nach Anspruch 2, wobei das Metalloxid zumindest eines umfasst, das aus der Gruppe, bestehend aus Vanadiumoxid (V₂O₅), Rheniumoxid (Re₂O₇) und Indiumzinnoxid (ITO) ausgewählt ist.

4. Organische Lumineszenzanzeigevorrichtung nach einem der vorhergehenden Ansprüche, wobei der p-Typ-Dotierungsstoff ein Energieniveau für ein niedrigstes unbesetztes Molekülorbital (LUMO) aufweist, wobei zumindest eine der ersten und der zweiten Lochinjektionsschicht ein Material umfasst, das ein Energieniveau für ein höchstes unbesetztes Molekülorbital (HOMO) aufweist, und wobei ein Unterschied zwischen dem Energieniveau für das niedrigste unbesetzte Molekülorbital (LUMO) des p-Typ-Dotierungsstoffs und dem Energieniveau für das höchste unbesetzte Molekülorbital (HOMO) des Materials der zumindest einen der ersten und zweiten Lochinjektionsschicht zwischen -2 eV und +2 eV beträgt.

5. Organische Lumineszenzanzeigevorrichtung nach einem der vorhergehenden Ansprüche, wobei die Vorrichtung eine Vielzahl von Pixeln umfasst und wobei die Ladungserzeugungsschicht eine gemeinsame Schicht für zumindest zwei der Pixel bildet.

6. Organische Lumineszenzanzeigevorrichtung nach einem der vorhergehenden Ansprüche, wobei die Ladungserzeugungsschicht eine Dicke in einem Bereich von 10 Å bis 200 Å aufweist.

7. Organische Lumineszenzanzeigevorrichtung nach Anspruch 6, wobei die Ladungserzeugungsschicht eine Dicke in einem Bereich von 20 Å bis 80 Å aufweist.

8. Organische Lumineszenzanzeigevorrichtung nach einem der vorhergehenden Ansprüche, ferner umfassend eine Lochtransportschicht, die zwischen der ersten Elektrode und der Emissionsschicht eingefügt ist, und zumindest eine von einer Lochblockierungsschicht, einer Elektronentransportschicht und einer Elektroneninjektionsschicht, die zwischen der Emissionsschicht und der zweiten Elektrode eingefügt ist.

9. Organische Lumineszenzanzeigevorrichtung nach einem der vorhergehenden Ansprüche, ferner umfassend eine Elektronentransportschicht, die zwischen der zweiten Elektrode und der Emissionsschicht eingefügt ist.

10. Organische Lumineszenzanzeigevorrichtung nach einem der vorhergehenden Ansprüche, ferner umfassend ein Substrat, wobei die erste Elektrode über dem Substrat gebildet ist.

11. Organische Lumineszenzanzeigevorrichtung nach Anspruch 9 oder 10, ferner umfassend eine Elektroneninjektionsschicht, die zwischen der Elektronentransportschicht und der zweiten Elektrode eingefügt ist.

12. Organische Lumineszenzanzeigevorrichtung nach einem der Ansprüche 9 bis 11, ferner umfassend eine Lochblockierungsschicht, die zwischen der Elektronentransportschicht und der Emissionsschicht eingefügt ist.

13. Elektronische Vorrichtung, umfassend eine organische Lumineszenzanzeigevorrichtung nach einem der vorhergehenden Ansprüche.

14. Verfahren zur Herstellung einer organischen Lumineszenzanzeigevorrichtung, wobei das Verfahren Folgendes umfasst:
das Bilden einer ersten Lochinjektionsschicht über einer ersten Elektrode;
das Bilden einer Ladungserzeugungsschicht über der ersten Lochinjektionsschicht, wobei die Ladungserzeugungsschicht mit einem p-Typ-Dotierungsstoff dotiert ist; und
das Bilden einer zweiten Lochinj ektionsschicht über der und die Ladungserzeugungsschicht berührend, **dadurch gekennzeichnet, dass** die Ladungserzeugungsschicht eine Verbindung umfasst, die durch die Formel 1 dargestellt wird: 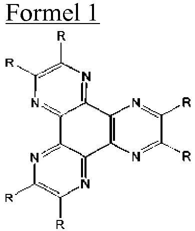
wobei R eine Nitril-(-CN)-Gruppe, eine Sulfon-(-SO₂R')-Gruppe, eine Sulfoxid-(-SOR')-Gruppe, eine Sulfonamid-(-SO₂NR'₂)-Gruppe, eine Sulfonat-(-SO₃R')-Gruppe, eine Nitro-(-NO₂)-Gruppe oder eine Trifluormethyl-(-CF₃)-Gruppe ist; und
wobei R' eine C₁-C₆₀-Alkylgruppe, eine C₆-C₆₀-Arylgruppe oder eine heterocyclische C₁-C₆₀-Gruppe ist, die nicht substituiert ist oder mit Amin, Amid, Ether oder Ester substituiert ist.

15. Verfahren nach Anspruch 14, ferner umfassend:
Bilden einer Emissionsschicht über der zweiten Lochinjektionsschicht; und
Bilden einer zweiten Elektrode über der Emissionsschicht.

16. Verfahren nach Anspruch 15, ferner umfassend:
Bilden einer Lochtransportschicht nach dem Bilden der zweiten Lochinjektionsschicht und vor dem Bilden der Emissionsschicht; und
Bilden zumindest einer von einer Lochblockierungsschicht, einer Elektronentransportschicht und einer Elektroneninjektionsschicht nach dem Bilden der Emissionsschicht und vor dem Bilden der zweiten Elektrode.

17. Verfahren nach einem der Ansprüche 14 bis 16, wobei der p-Typ-Dotierungsstoff zumindest eines umfasst, das aus der Gruppe, bestehend aus Hexanitrilhexaazatriphenylen, Tetrafluor-tetracyanchinodimethan (F₄-TCNQ), FeCl₃, F₁₆CuPc und einem Metalloxid, ausgewählt ist.

18. Verfahren nach Anspruch 17, wobei das Metalloxid zumindest eines ist, das aus der Gruppe, bestehend aus Vanadiumoxid (V₂O₅), Rheniumoxid (Re₂O₇) und Indiumzinnoxid (ITO) ausgewählt ist.

19. Verfahren nach einem der Ansprüche 14 bis 18, wobei der p-Typ-Dotierungsstoff ein Energieniveau für ein niedrigstes unbesetztes Molekülorbital (LUMO) aufweist, wobei zumindest eine der ersten und der zweiten Lochinjektionsschicht ein Material umfasst, das ein Energieniveau für ein höchstes unbesetztes Molekülorbital (HOMO) aufweist, und wobei ein Unterschied zwischen dem Energieniveau für das niedrigste unbesetzte Molekülorbital (LUMO) des p-Typ-Dotierungsstoffs und dem Energieniveau für das höchste unbesetzte Molekülorbital (HOMO) des Materials der zumindest einen der ersten und zweiten Lochinjektionsschicht zwischen -2 und +2 eV beträgt.

20. Verfahren nach einem der Ansprüche 14 bis 19, wobei das Bilden der Ladungserzeugungsschicht das Verwenden von Widerstandserhitzungsdampfabscheidung, Elektronenstrahldampfabscheidung, Laserstrahldampfabscheidung oder Sputterabscheidung umfasst.

21. Verfahren nach einem der Ansprüche 14 bis 21, wobei die Ladungserzeugungsschicht eine Dicke in einem Bereich von 10 Å bis 200 Å aufweist.

## Revendications

1. Dispositif d'affichage électroluminescent organique, comprenant :
une première électrode ;
une deuxième électrode ;
une couche d'émission interposée entre les première et deuxième électrodes ;
une première couche d'injection de trous interposée entre la première électrode et la couche d'émission ;
une deuxième couche d'injection de trous interposée entre la première couche d'injection de trous et la couche d'émission ; et
une couche de génération de charges interposée entre la première couche d'injection de trous et la deuxième couche d'injection de trous, la couche de génération de charges étant dopée avec un dopant de type p, **caractérisé en ce que** la couche de génération de charges comprend un composé représenté par la formule 1 : 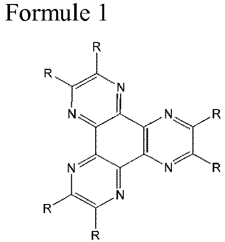
dans laquelle R est un groupe nitrile (-CN), un groupe sulfone (-SO₂R'), un groupe sulfoxyde (-SOR'), un groupe sulfonamide (-SO₂NR'₂), un groupe sulfonate (-SO₃R'), un groupe nitro (-NO₂), ou un groupe trifluorométhyle (-CF₃) ; et
dans laquelle R' est un groupe alkyle en C₁-C₆₀, un groupe aryle en C₆-C₆₀, ou un groupe hétérocyclique en C₁-C₆₀ et est non substitué ou est substitué avec une amine, un amide, un éther, ou un ester.

2. Dispositif d'affichage électroluminescent organique selon la revendication 1, dans lequel le dopant de type p comprend au moins un composé sélectionné parmi le groupe constitué de l'hexaazatriphénylène-hexanitrile, du tétrafluoro-tétracyanoquinodiméthane (F₄-TCNQ), de FeCl₃, de F₁₆CuPc et d'un oxyde métallique.

3. Dispositif d'affichage électroluminescent organique selon la revendication 2, dans lequel l'oxyde métallique comprend au moins un composé sélectionné parmi le groupe constitué de l'oxyde de vanadium (V₂O₅), de l'oxyde de rhénium (Re₂O₇), et de l'oxyde d'indium-étain (ITO).

4. Dispositif d'affichage électroluminescent organique selon l'une quelconque des revendications précédentes, dans lequel le dopant de type p présente un niveau d'énergie de la plus basse orbitale moléculaire inoccupée (LUMO), dans lequel au moins une parmi les première et deuxième couches d'injection de trous comprend un matériau présentant un niveau d'énergie de la plus haute orbitale moléculaire occupée (HOMO), et dans lequel une différence entre le niveau d'énergie de la plus basse orbitale moléculaire inoccupée (LUMO) du dopant de type p et le niveau d'énergie de la plus haute orbitale moléculaire occupée (HOMO) du matériau de la au moins une parmi les première et deuxième couches d'injection de trous est comprise entre -2 eV et +2 eV.

5. Dispositif d'affichage électroluminescent organique selon l'une quelconque des revendications précédentes, dans lequel le dispositif comprend une pluralité de pixels, et dans lequel la couche de génération de charges forme une couche commune pour au moins deux des pixels.

6. Dispositif d'affichage électroluminescent organique selon l'une quelconque des revendications précédentes, dans lequel la couche de génération de charges présente une épaisseur qui se situe dans une plage comprise entre 10 Å et 200 Å.

7. Dispositif d'affichage électroluminescent organique selon la revendication 6, dans lequel la couche de génération de charges présente une épaisseur qui se situe dans une plage comprise entre 20 Å et 80 Å.

8. Dispositif d'affichage électroluminescent organique selon l'une quelconque des revendications précédentes, comprenant en outre une couche de transport de trous interposée entre la première électrode et la couche d'émission, et au moins une parmi une couche de blocage de trous, une couche de transport d'électrons et une couche d'injection d'électrons interposée entre la couche d'émission et la deuxième électrode.

9. Dispositif d'affichage électroluminescent organique selon l'une quelconque des revendications précédentes, comprenant en outre une couche de transport d'électrons interposée entre la deuxième électrode et la couche d'émission.

10. Dispositif d'affichage électroluminescent organique selon l'une quelconque des revendications précédentes, comprenant en outre un substrat, dans lequel la première électrode est formée par-dessus le substrat.

11. Dispositif d'affichage électroluminescent organique selon la revendication 9 ou 10, comprenant en outre une couche d'injection d'électrons interposée entre la couche de transport d'électrons et la deuxième électrode.

12. Dispositif d'affichage électroluminescent organique selon l'une quelconque des revendications 9 à 11, comprenant en outre une couche de blocage de trous interposée entre la couche de transport d'électrons et la couche d'émission.

13. Dispositif électronique comprenant un dispositif d'affichage électroluminescent organique selon l'une quelconque des revendications précédentes.

14. Procédé de fabrication d'un dispositif d'affichage électroluminescent organique, le procédé comprenant les étapes consistant à :
former une première couche d'injection de trous par-dessus une première électrode ;
former une couche de génération de charges par-dessus la première couche d'injection de trous ; la couche de génération de charges étant dopée avec un dopant de type p ; et
former une deuxième couche d'injection de trous par-dessus, et venant en contact avec, la couche de génération de charges, **caractérisé en ce que** la couche de génération de charges comprend un composé représenté par la formule I : 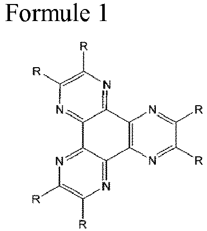
dans laquelle R est un groupe nitrile (-CN), un groupe sulfone (-SO₂R'), un groupe sulfoxyde (-SOR'), un groupe sulfonamide (-SO₂NR'₂), un groupe sulfonate (-SO₃R'), un groupe nitro (-NO₂), ou un groupe trifluorométhyle (-CF₃) ; et
dans laquelle R' est un groupe alkyle en C₁-C₆₀, un groupe aryle en C₆-C₆₀, ou un groupe hétérocyclique en C₁-C₆₀ et n'est pas substitué ou est substitué avec une amine, un amide, un éther, ou un ester.

15. Procédé selon la revendication 14, comprenant en outre les étapes consistant à :
former une couche d'émission par-dessus la deuxième couche d'injection de trous ; et
former une deuxième électrode par-dessus la couche d'émission.

16. Procédé selon la revendication 15, comprenant en outre les étapes consistant à :
former une couche de transport de trous après formation de la deuxième couche d'injection de trous et avant formation de la couche d'émission ; et
former au moins une parmi une couche de blocage de trous, une couche de transport d'électrons et une couche d'injection d'électrons après formation de la couche d'émission et avant formation de la deuxième électrode.

17. Procédé selon l'une quelconque des revendications 14 à 16, dans lequel le dopant de type p comprend au moins un composé sélectionné parmi le groupe constitué de l'hexaazatriphénylène-hexanitrile, du tétrafluoro-tétracyanoquinodiméthane (F₄-TCNQ), de FeCl₃, de F₁₆CuPc et d'un oxyde métallique.

18. Procédé selon la revendication 17, dans lequel l'oxyde métallique est au moins un composé sélectionné parmi le groupe constitué de l'oxyde de vanadium (V₂O₅), de l'oxyde de rhénium (Re₂O₇), et de l'oxyde d'indium-étain (ITO).

19. Procédé selon l'une quelconque des revendications 14 à 18, dans lequel le dopant de type p présente un niveau d'énergie de la plus basse orbitale moléculaire inoccupée (LUMO), dans lequel au moins une parmi les première et deuxième couches d'injection de trous comprend un matériau présentant un niveau d'énergie de la plus haute orbitale moléculaire occupée (HOMO), et dans lequel une différence entre le niveau d'énergie de la plus basse orbitale moléculaire inoccupée (LUMO) du dopant de type p et le niveau d'énergie de la plus haute orbitale moléculaire occupée (HOMO) du matériau de la au moins une parmi les première et deuxième couches d'injection de trous est comprise entre -2 et +2 eV.

20. Procédé selon l'une quelconque des revendications 14 à 19, dans lequel la formation de la couche de génération de charges comprend une étape consistant à utiliser un dépôt en phase vapeur avec chauffage par résistance, un dépôt en phase vapeur assisté par faisceau d'électrons, un dépôt en phase vapeur assisté par faisceau laser, ou un dépôt par pulvérisation.

21. Procédé selon l'une quelconque des revendications 14 à 21, dans lequel la couche de génération de charges présente une épaisseur qui se situe dans une plage comprise entre 10 Å et 200 Å.
